(19) Europäisches Patentamt
European Patent Office
Office européen des brevets

(11) **EP 1 796 139 A1**

(12) **EUROPEAN PATENT APPLICATION**
published in accordance with Art. 158(3) EPC

(43) Date of publication:
**13.06.2007 Bulletin 2007/24**

(51) Int Cl.:
*H01L 21/027* (2006.01)    *G03F 7/20* (2006.01)
*G02B 5/30* (2006.01)    *G02B 7/02* (2006.01)
*G02B 7/00* (2006.01)    *G02B 13/24* (2006.01)

(21) Application number: **05766348.6**

(22) Date of filing: **21.07.2005**

(86) International application number:
**PCT/JP2005/013410**

(87) International publication number:
**WO 2006/016469 (16.02.2006 Gazette 2006/07)**

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **10.08.2004 JP 2004233006**

(71) Applicant: **NIKON CORPORATION
Tokyo 100-8831 (JP)**

(72) Inventor: **KUDO, Yuji,
c/o NIKON CORPORATION
Tokyo 1008331 (JP)**

(74) Representative: **HOFFMANN EITLE
Patent- und Rechtsanwälte
Arabellastrasse 4
81925 München (DE)**

(54) **ILLUMINATION OPTICAL EQUIPMENT, EXPOSURE SYSTEM AND METHOD**

(57)    An illumination optical apparatus is able to well suppress a change in a polarization state of light in an optical path and to illuminate a surface to be illuminated, with light in a desired polarization state or in an unpolarized state. The illumination optical apparatus illuminates the surface to be illuminated (M), based on light with a polarization degree of not less than 0.9 supplied from a light source (1). The illumination optical apparatus comprises a polarization setter (4, 10) disposed in the optical path between the light source and the surface to be illuminated, and adapted for setting a polarization state of light reaching the surface to be illuminated, to a predetermined polarization state, and a holding member for supporting one optical surface of at least one optically transparent member incorporated in an optical system in the optical path between the light source and the surface to be illuminated, at three points located in three regions respectively.

**Fig.1**

**Description**

Technical Field

The present invention relates to an illumination optical apparatus, exposure apparatus, and exposure method and, more particularly, to an exposure apparatus for manufacturing microdevices, such as semiconductor devices, image pickup devices, liquid-crystal display devices, and thin-film magnetic heads, by lithography.

Background Art

In the typical exposure apparatus of this type, a light beam emitted from a light source is guided through a fly's eye lens as an optical integrator to form a secondary light source as a substantive surface light source comprising a lot of light sources. Light beams from the secondary light source (generally, an illumination pupil distribution formed on or near an illumination pupil of an illumination optical apparatus) are guided through an aperture stop disposed in the vicinity of the rear focal plane of the fly's eye lens, to be limited, and then enter a condenser lens.

The light beams converged by the condenser lens illuminate a mask with a predetermined pattern thereon, in a superposed manner. Light transmitted by the pattern of the mask travels through a projection optical system to be focused on a wafer. In this manner the mask pattern is projected (or transferred) onto the wafer to effect exposure thereof. The pattern formed on the mask is of high integration and a uniform illuminance distribution must be formed on the wafer in order to accurately transfer the microscopic pattern onto the wafer.

For example, Japanese Patent No. 3246615 based on an application filed by the Applicant of the present application discloses the technology for realizing an illumination condition suitable for faithfully transferring a microscopic pattern along any direction, in which the secondary light source of an annular shape is formed on the rear focal plane of the fly's eye lens and in which light beams passing through this annular secondary light source are set in a linear polarization state with a polarization direction along a circumferential direction of the annular shape (which will be referred to hereinafter as "circumferential polarization state").

Patent Document 1: Japanese Patent No. 3246615

Disclosure of the Invention

Problem to be Solved by the Invention

Besides the foregoing circumferential polarization state, projection exposure with light in a specific linear polarization state is effective to improvement in resolution of the projection optical system. Furthermore, projection exposure with light in a specific polarization state or in an unpolarized state according to a mask pattern is generally effective to improvement in resolution of the projection optical system.

However, when an optical element that can change the polarization state of light is interposed in the illumination optical path, the light will fail to be focused in the desired polarization state or in the unpolarized state even in a configuration wherein a mask (and a wafer eventually) is to be illuminated with light in a desired polarization state or in an unpolarized state and this could degrade imaging performance. Particularly, when the optical element is an optically transparent member like a lens or a plane-parallel plate disposed in the illumination optical path between the light source and the mask, birefringence arises with external force acting on the member and this birefringence causes a change in the polarization state of passing light.

An object of the present invention is to provide an illumination optical apparatus capable of well suppressing the change in the polarization state of light in the optical path and illuminating a surface to be illuminated, with light in a desired polarization state or in an unpolarized state.

Another object of the present invention is to provide an exposure apparatus and exposure method capable of faithfully transferring a microscopic pattern onto a photosensitive substrate on the basis of a desired illumination condition according to a mask pattern, using an illumination optical apparatus for illuminating a mask as a surface to be illuminated, with light in a desired polarization state or in an unpolarized state.

Means for Solving the Problem

In order to achieve the foregoing objects, a first aspect of the present invention provides an illumination optical apparatus for illuminating a surface to be illuminated, the illumination optical apparatus comprising:

a polarization setter disposed in an optical path between a light source for supplying light having a polarization degree of not less than 0.9, and the surface to be illuminated, and adapted for setting a polarization state of light reaching the surface to be illuminated, to a predetermined polarization state; and

a holding member for supporting one optical surface of at least one optically transparent member incorporated in an optical system in the optical path between the light source and the surface to be illuminated, at three points located in three regions respectively.

A second aspect of the present invention provides an exposure apparatus comprising the illumination optical apparatus of the first aspect for illuminating a mask, and adapted for exposure of a pattern of the mask on a photosensitive substrate.

A third aspect of the present invention provides an exposure method comprising an illumination step of illuminating a mask by means of the illumination optical apparatus of the first aspect; and an exposure step of effecting exposure of a pattern of the mask on a photosensitive substrate.

Effect of the Invention

In the illumination optical apparatus according to the typical aspect of the present invention, an optically transparent member needed (generally, at least one optically transparent member) among those disposed in the optical path is supported from both sides and a surface of the optically transparent member on each side is supported at three points located in three regions respectively which are substantially opposed to the three regions on the other surface. In this case, there appear stress distributions concentrated only on the supported regions of the optically transparent member, with no substantial stress distributions in the effective region of the optically transparent member. As a result, there arises little birefringence due to stress distribution and there is thus little change in the polarization state of passing light due to birefringence.

In this manner, the illumination optical apparatus of the present invention is able to well suppress the change in the polarization state of light in the optical path and to illuminate the surface to be illuminated, with light in a desired polarization state or in an unpolarized state. Therefore, the exposure apparatus and exposure method of the present invention are able to faithfully transfer a microscopic pattern onto a photosensitive substrate on the basis of a desired illumination condition according to the mask pattern, using the illumination optical apparatus for illuminating the mask as the surface to be illuminated, with light in the desired polarization state or in the unpolarized state, and are thus able to manufacture a good device.

Brief Description of the Drawings

Fig. 1 is a drawing schematically showing a configuration of an exposure apparatus according to an embodiment of the present invention.
Fig. 2 is a drawing schematically showing a configuration of a polarization converting element in Fig. 1.
Fig. 3 is a drawing for explaining the optical rotation of rock crystal.
Fig. 4 is a drawing schematically showing an annular secondary light source set in a circumferential polarization state by operation of a polarization converting element.
Fig. 5 is a drawing schematically showing external forces acting on an optically transparent member and a stress distribution appearing in the optically transparent member in the conventional technology.

Fig. 6 is a drawing schematically showing external forces acting on an optically transparent member and a stress distribution appearing in the optically transparent member in the embodiment.
Fig. 7 is a drawing schematically showing a configuration of a holding member for supporting an optically transparent member at three points from both sides in the embodiment.
Fig. 8 is a drawing schematically showing an annular secondary light source set in a radial polarization state by operation of a polarization converting element.
Fig. 9 is a flowchart of a technique of manufacturing semiconductor devices as microdevices.
Fig. 10 is a flowchart of a technique of manufacturing a liquid-crystal display element as a microdevice.

Best Mode for Carrying out the Invention

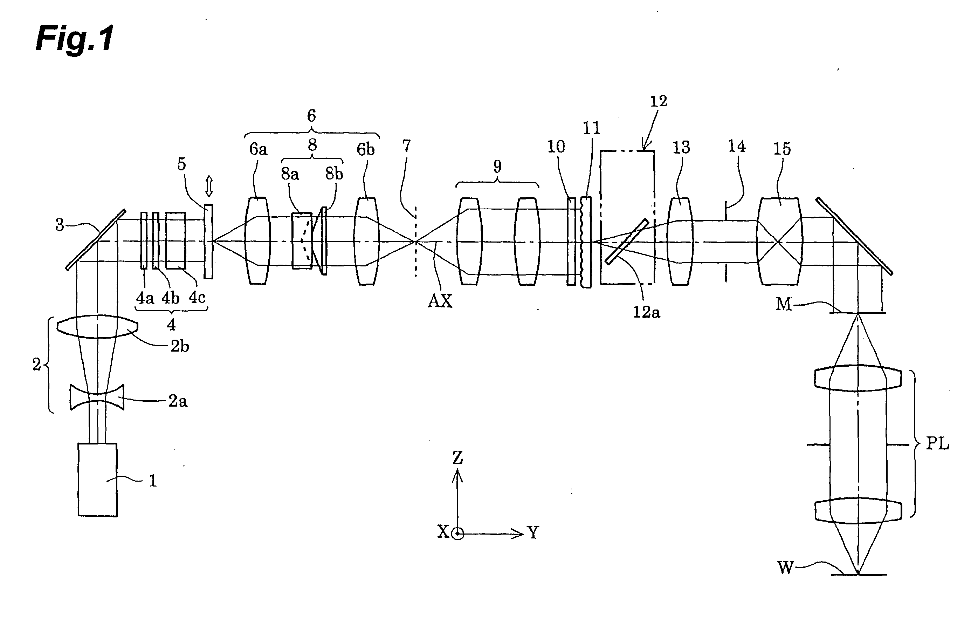

Embodiments of the present invention will be described on the basis of the accompanying drawings. Fig. 1 is a drawing schematically showing a configuration of an exposure apparatus according to an embodiment of the present invention. In Fig. 1, the Z-axis is set along a direction of a normal to a wafer W being a photosensitive substrate, the Y-axis along a direction parallel to the page of Fig. 1 in the surface of wafer W, and the X-axis along a direction perpendicular to the paper of Fig. 1 in the surface of wafer W. With reference to Fig. 1, the exposure apparatus of the present embodiment is provided with a light source 1 for supplying exposure light (illumination light).

The light source 1 to be used can be, for example, a KrF excimer laser light source for supplying light of wavelength of 193 nm, an ArF excimer laser light source for supplying light of wavelength of 193 nm, or the like. A nearly parallel light beam emitted along the Z-direction from the light source 1 has a rectangular cross section extending obliquely along the X-direction and is incident to a beam expander 2 consisting of a pair of lenses 2a and 2b. The lenses 2a and 2b have a negative refractive power and a positive refractive power, respectively, in the page of Fig. 1 (i.e., in the YZ plane). Therefore, the light beam incident to the beam expander 2 is expanded and shaped in the page of Fig. 1 so that a light beam has a predetermined rectangular cross section.

The nearly parallel light beam having passed through the beam expander 2 as a shaping optical system is deflected into the Y-direction by a bending mirror 3, and then travels via a quarter-wave plate 4a, a half-wave plate 4b, a depolarizer (depolarizing element) 4c, and a diffractive optical element 5 for annular illumination, to enter an afocal lens 6. The quarter-wave plate 4a, half-wave plate 4b, and depolarizer 4c herein constitute a polarization state switch 4, as described later. The afocal lens 6 is an afocal system (afocal optic) so set that the front focal position of a front lens unit 6a is approximately coincident with the position of the diffractive optical element 5 and that the rear focal position of a rear lens unit 6b is approximately coincident with a position of a predetermined plane 7 indicated by a dashed line in the drawing.

In general, a diffractive optical element is made by forming steps with a pitch approximately equal to the wavelength of the exposure light (illumination light) in a substrate, and functions to diffract an incident light beam at desired angles. Specifically, the diffractive optical element 5 for annular illumination has the following function: when a parallel light beam having a rectangular cross section is incident to the diffractive optical element 5, a light intensity distribution of an annular shape is formed in its far field (or Fraunhofer diffraction region).

Therefore, the nearly parallel light beam incident to the diffractive optical element 5 as a light beam conversion element forms an annular light intensity distribution on the pupil plane of the afocal lens 6 and thereafter exits with an annular angular distribution from the afocal lens 6. A conical axicon system 8 is disposed in the optical path between the front lens unit 6a and the rear lens unit 6b of the afocal lens 6 and at or near the pupil plane thereof, and the detailed configuration and operation thereof will be described later. For simplification of description, the basic configuration and operation will be described below, while ignoring the operation of the conical axicon system 8.

The light beam having passed through the afocal lens 6 travels through a zoom lens 9 for varying σ-value and through a polarization converting element 10 to enter a micro fly's eye lens (or fly's eye lens) 11 as an optical integrator. The configuration and operation of the polarization converting element 10 will be described later. The micro fly's eye lens 11 is an optical element comprising a number of microscopic lenses with a positive refractive power arranged vertically and horizontally and densely. In general, a micro fly's eye lens is made, for example, by etching a plane-parallel plate to form a microscopic lens group.

Each of the microscopic lenses of the micro fly's eye lens is smaller than each of lens elements of a fly's eye lens. The micro fly's eye lens is a lens wherein a number of microscopic lenses (microscopic refracting faces) are integrally formed without being isolated from each other, different from the fly's eye lens comprising lens elements isolated from each other. However, the micro fly's eye lens is a wavefront dividing type optical integrator as well as the fly's eye lens in that the lens elements with a positive refractive power are arranged vertically and horizontally.

The predetermined plane 7 is disposed near the front focal position of the zoom lens 9 and the entrance surface of the micro fly's eye lens 11 is disposed near the rear focal position of the zoom lens 9. In other words, the zoom lens 9 functions to arrange the predetermined plane 7 and the entrance surface of the micro fly's eye lens 11 substantially in the relation of Fourier transform and, eventually, to arrange the pupil plane of the afocal lens 6 and the entrance surface of the micro fly's eye lens 11 substantially optically conjugate with each other.

Therefore, for example, an annular illumination field is formed around the optical axis AX on the entrance surface of the micro fly's eye lens 11, as on the pupil plane of the afocal lens 6. The overall shape of this annular illumination field varies similarly depending upon the focal length of the zoom lens 9. Each microscopic lens which the micro fly's eye lens 11 comprises has a rectangular cross section similar to a shape of an illumination field to be formed on a mask M (and, eventually, similar to a shape of an exposure region to be formed on a wafer W).

The light beam incident to the micro fly's eye lens 11 is two-dimensionally divided by the multiple microscopic lenses to form a secondary light source having much the same light intensity distribution as the illumination field formed by the incident light beam, i.e., a secondary light source consisting of a substantive surface light source of an annular shape around the optical axis AX, on or near the rear focal plane of the micro fly's eye lens 11 (and on the illumination pupil eventually). Beams from the secondary light source formed on or near the rear focal plane of the micro fly's eye lens 11 travel through a beam splitter 12a and a condenser optical system 13 and then illuminate a mask blind 14 disposed at a position nearly optically conjugate with the mask M or the wafer W as a surface to be illuminated, in a superposed manner.

In this manner, a rectangular illumination field according to the shape and focal length of each microscopic lens which the micro fly's eye lens 11 comprises is formed on the mask blind 14 as an illumination field stop. The light beam having passed through a rectangular aperture (light transmitting portion) of the mask blind 14 is subject to focusing operation of an imaging optical system 15 and then illuminates the mask M with the predetermined pattern therein, in a superposed manner. Namely, the imaging optical system 15 guides the light having passed through the mask blind 14 disposed at the position nearly optically conjugate with the mask M or the wafer W as a surface to be illuminated, to the mask M and forms an image of the rectangular aperture of the mask blind 14 on the mask M.

The light beam transmitted by the pattern of the mask M travels through a projection optical system PL to form an image of the mask pattern on the wafer W as a photosensitive substrate. While the wafer W is two-dimensionally driven and controlled in the plane (XY plane) perpendicular to the optical axis AX of the projection optical system PL, one-shot exposure or scan exposure is effected to sequentially project the pattern of the mask M into each of exposure regions on the wafer W.

In the polarization state switch 4, the quarter-wave plate 4a is so arranged that the crystallographic axis thereof is rotatable around the optical axis AX, and converts incident light of elliptic polarization into light in linear polarization. The half-wave plate 4b is so arranged that the crystallographic axis thereof is rotatable around the optical axis AX, and changes the polarization plane of incident linearly polarized light. The depolarizer 4c is composed of a rock crystal prism and a silica glass prism of wedge shapes complementary to each other. The rock crystal prism and the silica glass prism are constructed as an integral prism assembly so as to be freely inserted into or retracted from the illumination optical path.

When the light source 1 is a KrF excimer laser light source or an ArF excimer laser light source, light emitted from these light sources typically has the polarization degree of not less than 95% and nearly linearly polarized light is incident to the quarter-wave plate 4a. However, if a right-angle prism is interposed as a back reflector in the optical path between the light source 1 and the polarization state switch 4, total reflection in the right-angle prism will convert linear polarization into elliptic polarization unless the polarization plane of the incident linearly polarized light coincides with the p-polarization plane or s-polarization plane.

In the polarization state switch 4, for example, even if light in elliptic polarization is incident to the polarization state switch 4 because of the total reflection in the right-angle prism, it will be converted into light in linear polarization by the operation of the quarter-wave plate 4a and the linearly polarized light will be incident to the half-wave plate 4b. When the crystallographic axis of the half-wave plate 4b is set at an angle of 0° or 90° relative to the polarization plane of incident linearly polarized light, the light in linear polarization incident to the half-wave plate 4b passes through the half-wave plate 4b without change in the polarization plane.

When the crystallographic axis of the half-wave plate 4b is set at an angle of 45° relative to the polarization plane of incident linearly polarized light, the light in linear polarization incident to the half-wave plate 4b is converted into light in linear polarization with the polarization plane changed by 90°. Furthermore, when the crystallographic axis of the rock crystal prism of the depolarizer 4c is set at an angle of 45° relative to the polarization plane of incident linearly polarized light, the light in linear polarization incident to the rock crystal prism is converted (or depolarized) into light in an unpolarized state.

The polarization state switch 4 is so arranged that the crystallographic axis of the rock crystal prism makes the angle of 45° relative to the polarization plane of incident linearly polarized light when the depolarizer 4c is positioned in the illumination optical path. In passing, if the crystallographic axis of the rock crystal prism is set at an angle of 0° or 90° relative to the polarization plane of incident linearly polarized light, the linearly polarized light incident to the rock crystal prism will pass directly without change in the polarization plane.

In the polarization state switch 4, as described above, the light in linear polarization is incident to the half-wave plate 4b, and let us assume herein that light in linear polarization with the polarization direction (the direction of the electric field) along the Z-direction in Fig. 1 (which will be referred to hereinafter as "Z-directional polarization") is incident to the half-wave plate 4b, for simplification of the description hereinafter. When the depolarizer 4c is positioned in the illumination optical path and when the crystallographic axis of the half-wave plate 4b is set at the angle of 0° or 90° relative to the polarization plane (direction of polarization) of incident Z-directionally polarized light, the light in Z-directional polarization incident to the half-wave plate 4b passes as Z-directionally polarized light without change in the polarization plane and then is incident to the rock crystal prism of the depolarizer 4c. Since the crystallographic axis of the rock crystal prism is set at the angle of 45° relative to the polarization plane of the incident Z-directionally polarized light, the light in Z-directional polarization incident to the rock crystal prism is converted into light in an unpolarized state.

The light depolarized through the rock crystal prism travels through a silica glass prism as a compensator for compensating the traveling direction of light, and is then incident in an unpolarized state into the diffractive optical element 5. On the other hand, when the crystallographic axis of the half-wave plate 4b is set at the angle of 45° relative to the polarization plane of the incident Z-directionally polarized light, the light in Z-directional polarization incident to the half-wave plate 4b is converted into light with the polarization plane changed by 90°, i.e., light in linear polarization having the direction of polarization (direction of the electric field) along the X-direction in Fig. 1 (which will be referred to hereinafter as "X-directional polarization") to enter the rock crystal prism of the depolarizer 4c. Since the crystallographic axis of the rock crystal prism is also set at the angle of 45° relative to the polarization plane of the incident X-directionally polarized light, the light in the X-directional polarization incident to the rock crystal prism is converted into light in an unpolarized state to travel through the silica glass prism and then to be incident in an unpolarized state to the diffractive optical element 5.

In contrast to it, when the depolarizer 4c is retracted from the illumination optical path and when the crystallographic axis of the half-wave plate 4b is set at the angle of 0° or 90° relative to the polarization plane of the incident Z-directionally polarized light, the light in Z-directional polarization incident to the half-wave plate 4b passes as Z-directionally polarized light without change in the polarization plane, and is incident in a Z-directional polarization state to the diffractive optical element 5. On the other hand, when the crystallographic axis of the half-wave plate 4b is set at the angle of 45° relative to the polarization plane of the incident Z-directionally polarized light, the light in Z-directional polarization incident to the half-wave plate 4b is converted into light in X-directional polarization with the polarization plane changed by 90°, and is incident in an X-directional polarization state to the diffractive optical element 5.

As described above, the polarization state switch 4 is able to make the light in the unpolarized state incident to the diffractive optical element 5 when the depolarizer 4c is inserted and positioned in the illumination optical path. It is also able to make the light in the Z-directional polarization state incident to the diffractive optical element 5 when the depolarizer 4c is retracted from the illumination optical path and when the crystallographic axis of the half-wave plate 4b is set at the angle of 0° or 90° relative to the polarization plane of the incident Z-directionally polarized light. Furthermore, it is also able to make the light in the X-directional polarization state incident to the diffractive optical element 5 when the depolarizer 4c is retracted from the illumination optical path and when the crystallographic axis of the half-wave plate 4b is set at the angle of 45° relative to the polarization plane of the incident Z-directionally polarized light.

In other words, the polarization state switch 4 is able to switch the polarization state of light incident to the diffractive optical element 5 (consequently, the polarization state of light to illuminate the mask M and wafer W) between a linear polarization state and the unpolarized state and, in the case of the linear polarization state, it is able to switch the polarization of incident light between polarization states orthogonal to each other (i.e., between the Z-directional polarization and the X-directional polarization), through the operation of the polarization state switch comprising the quarter-wave plate 4a, the half-wave plate 4b, and the depolarizer 4c.

Furthermore, the polarization state switch 4 is able to make light in a circular polarization state incident to the diffractive optical element 5, when so set that the half-wave plate 4b and the depolarizer 4c both are retracted from the illumination optical path and that the crystallographic axis of the quarter-wave plate 4a is set at a predetermined angle relative to incident elliptically polarized light. In general, the half-wave plate 4b can act to set the polarization state of incident light to the diffractive optical element 5 to a linear polarization state with the polarization direction along an arbitrary direction.

Next, the conical axicon system 8 comprises a first prism member 8a a plane of which faces the light source side and a refracting surface of a concave conical shape of which faces the mask side, and a second prism member 8b a plane of which faces the mask side and a refracting surface of a convex conical shape of which faces the light source side, in order from the light source side. Then the refracting surface of the concave conical shape of the first prism member 8a and the refracting surface of the convex conical shape of the second prism member 8b are formed in such complementary shapes as to be able to butt each other. At least one of the first prism member 8a and the second prism member 8b is arranged to be movable along the optical axis AX to vary the distance between the refracting surface of the concave conical shape of the first prism member 8a and the refracting surface of the convex conical shape of the second prism member 8b.

In a state in which the refracting surface of the concave conical shape of the first prism member 8a butts on the refracting surface of the convex conical shape of the second prism member 8b, the conical axicon system 8 functions as a plane-parallel plate and has no effect on the secondary light source of annular shape formed. However, when the refracting surface of the concave conical shape of the first prism member 8a is disposed apart from the refracting surface of the convex conical shape of the second prism member 8b, the outside diameter (inside diameter) of the annular secondary light source varies while the width of the annular secondary light source (half of the difference between the outside diameter and the inside diameter of the annular secondary light source) is kept constant. Namely, an annular ratio (inside diameter/outside diameter) and the size (outside diameter) of the annular secondary light source change.

The zoom lens 9 has a function of similarly enlarging or reducing the overall shape of the annular secondary light source. For example, when the focal length of the zoom lens 9 is increased from a minimum to a predetermined value, the overall shape of the annular secondary light source is similarly enlarged. In other words, the width and size (outside diameter) of the annular secondary light source vary without change in the annular ratio thereof, through the operation of the zoom lens 9. In this manner, the annular ratio and size (outside diameter) of the annular secondary light source can be controlled by the operation of the conical axicon system 8 and the zoom lens 9.

A polarization monitor 12 is provided with a first beam splitter 12a disposed in the optical path between the micro fly's eye lens 11 and the condenser optical system 13, and has a function of detecting a polarization state of incident light to this first beam splitter 12a. When a controller confirms that the illumination light to the mask M (and to the wafer W eventually) is not in a desired polarization state or in an unpolarized state on the basis of the detection result by the polarization monitor 12, it drives and adjusts the quarter-wave plate 4a, half-wave plate 4b, and depolarizer 4c which the polarization state switch 4 comprises, to adjust the state of the illumination light to the mask M into the desired polarization state or into the unpolarized state.

When a diffractive optical element for quadrupole illumination (not shown) is set in the illumination optical path, instead of the diffractive optical element 5 for annular illumination, it can effect quadrupole illumination. The diffractive optical element for quadrupole illumination has the following function: when a parallel light beam having a rectangular cross section is incident thereto, it forms a light intensity distribution of quadrupole shape in its far field. Therefore, light beams having passed through the diffractive optical element for quadrupole illumination form an illumination field of quadrupole shape consisting of four circular illumination fields around the optical axis AX, for example, on the entrance surface of the micro fly's eye lens 11. As a result, the secondary light source of the same quadrupole shape as the illumination field formed on the entrance surface is also formed on or near the rear focal plane of the micro fly's eye lens 11.

When a diffractive optical element for circular illumination (not shown) is set in the illumination optical path, instead of the diffractive optical element 5 for annular illumination, it can effect normal circular illumination. The diffractive optical element for circular illumination has the following function: when a parallel light beam having a rectangular cross section is incident thereto, it forms a light intensity distribution of circular shape in its far field. Therefore, a light beam having passed through the diffractive optical element for circular illumination forms an illumination field of a circular shape centered around the optical axis AX, for example, on the entrance surface of the micro fly's eye lens 11. As a result, the secondary light source of the same circular shape as the illumination field formed on the entrance surface is also formed on or near the rear focal plane of the micro fly's eye lens 11.

Furthermore, when another diffractive optical element for multi-pole illumination (not shown) is set in the illumination optical path, instead of the diffractive optical element 5 for annular illumination, it is feasible to implement one of various multi-pole illuminations (dipole illumination, octupole illumination, etc.). Similarly, when a diffractive optical element with an appropriate characteristic (not shown) is set in the illumination optical path, instead of the diffractive optical element 5 for annular illumination, it becomes feasible to implement one of modified illuminations of various forms.

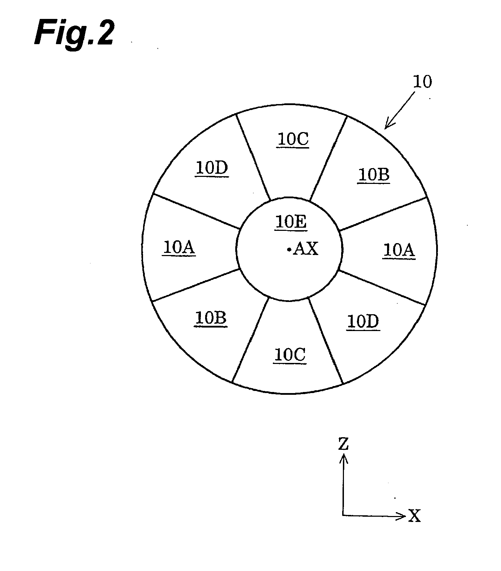

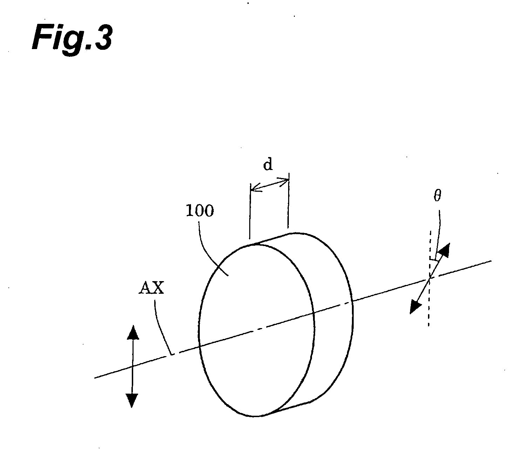

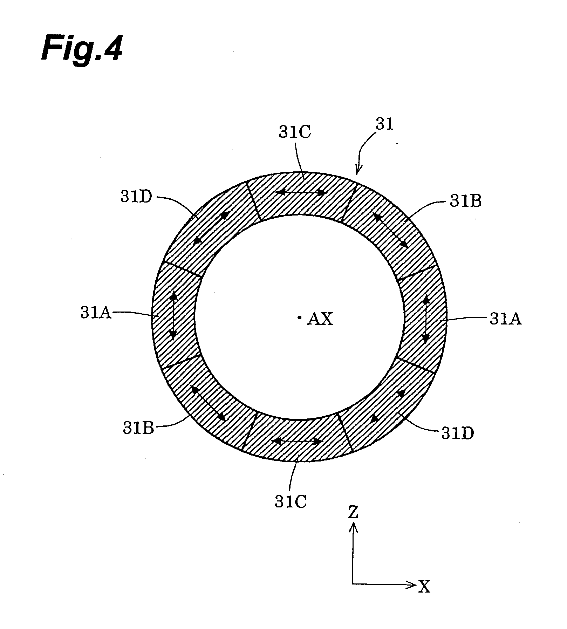

Fig. 2 is a drawing schematically showing the configuration of the polarization converting element shown in Fig. 1. Fig. 3 is a drawing for explaining the optical rotation of rock crystal. Fig. 4 is a drawing schematically showing an annular secondary light source set in the circumferential polarization state by the operation of the polarization converting element. The polarization converting element 10 according to the present embodiment is disposed immediately before the micro fly's eye lens 11, i.e., on or near the pupil of the illumination optical apparatus (1-PL). Therefore, in the case of annular illumination, a light beam having an approximately annular cross section around the optical axis AX is incident to the polarization converting element 10.

With reference to Fig. 2, the polarization converting element 10 has an annular effective region around the optical axis AX as a whole, and is composed of eight sector basic elements equally divided in the circumferential direction around the optical axis AX. Among these eight basic elements, a pair of basic elements facing each other on both sides of the optical axis AX have characteristics equal to each other. Namely, the eight basic elements include four types of basic elements 10A-10D having mutually different thicknesses along the direction of transmission of light (Y-direction) (i.e., lengths in the optical-axis direction).

Specifically, the thicknesses are set as follows:

the thickness of the first basic element 10A is the largest, the thickness of the fourth basic element 10D the smallest, and the thickness of the second basic element 10B is larger than the thickness of the third basic element 10C. As a result, one surface (e.g., entrance surface) of the polarization converting element 10 is planar, while the other surface (e.g., exit surface) is uneven because of the differences among the thicknesses of the respective basic elements 10A-10D. It is also possible to form the both surfaces of the polarization converting element 10 (the entrance surface and exit surface) in uneven shape.

In the present embodiment, each basic element 10A-10D is made of rock crystal being an optical material with optical rotation, and the crystallographic axis of each basic element 10A-10D is set to be approximately coincident with the optical axis AX. The optical rotation of rock crystal will be briefly described below with reference to Fig. 3. With reference to Fig. 3, an optical member 100 of a plane-parallel plate shape made of rock crystal and having a thickness d is arranged so that its crystallographic axis coincides with the optical axis AX. In this case, the direction of polarization of incident linearly polarized light is rotated by θ around the optical axis AX by the optical rotation of the optical member 100 and the light is outputted in the θ-rotated state.

At this time, a rotation angle (angle of rotation) θ of the polarization direction by the optical rotation of the optical member 100 is expressed by Eq (1) below, using the thickness d of the optical member 100 and the optical rotation p of rock crystal.

$$\theta = d \cdot \rho \qquad (1)$$

In general, the optical rotation p of rock crystal has wavelength dependence (a property in which the value of optical rotation differs depending upon the wavelength of used light: optical rotatory dispersion) and, specifically, it tends to increase with decrease in the wavelength of used light. According to the description on p167 in "Applied Optics II," the optical rotation p of rock crystal for light with the wavelength of 250.3 nm is 153.9°/mm.

In the present embodiment, the first basic element 10A has the thickness dA set as follows: when linearly polarized light having the polarization direction along the Z-direction is incident thereto, it outputs linearly polarized light having the polarization direction along a direction resulting from +180° rotation of the Z-direction around the Y-axis, i.e., along the Z-direction. In this case, therefore, the Z-direction is a direction of polarization of beams passing through a pair of arcuate regions 31A formed by beams subject to the optically rotating operation of the pair of first basic elements 10A, in the annular secondary light source 31 shown in Fig. 4.

The second basic element 10B has the thickness dB set as follows: when linearly polarized light having the polarization direction along the Z-direction is incident thereto, it outputs linearly polarized light having the polarization direction along a direction resulting from +135° rotation of the Z-direction around the Y-axis, i.e., along a direction resulting from -45° rotation of the Z-direction around the Y-axis. In this case, therefore, the direction resulting from -45° rotation of the Z-direction around the Y-axis is the polarization direction of beams passing through a pair of arcuate regions 31 B formed by beams subject to the optically rotating operation of the pair of second basic elements 10B, in the annular secondary light source 31 shown in Fig. 4.

The third basic element 10C has the thickness dC set as follows: when linearly polarized light having the polarization direction along the Z-direction is incident thereto, it outputs linearly polarized light having the polarization direction along a direction resulting from +90° rotation of the Z-direction around the Y-axis, i.e., along the X-direction. In this case, therefore, the X-direction is the polarization direction of beams passing through a pair of arcuate regions 31 C formed by beams subject to the optically rotating operation of the pair of third basic elements 10C, in the annular secondary light source 31 shown in Fig. 4.

The fourth basic element 10D has the thickness dD set as follows: when linearly polarized light having the polarization direction along the Z-direction is incident thereto, it outputs linearly polarized light having the polarization direction along a direction resulting from +45° rotation of the Z-direction around the Y-axis. In this case, therefore, the direction resulting from +45° rotation of the Z-direction around the Y-axis is the polarization direction of beams passing through a pair of arcuate regions 31D formed by beams subject to the optically rotating operation of the pair of fourth basic elements 10D, in the annular secondary light source 31 shown in Fig. 4.

The polarization converting element 10 can be manufactured by combining the eight basic elements formed separately, or the polarization converting element 10 can also be manufactured by forming the required uneven shape (steps) in a rock crystal substrate of a plane-parallel plate shape. In order to implement normal circular illumination without retracting the polarization converting element 10 from the optical path, there is provided a circular center region 10E having a size not less than one third of the radial size of the effective region of the polarization converting element 10 and having no optical rotation. The center region 10E herein may be made of an optical material without optical rotation, e.g., like silica glass, or may be simply a circular aperture. It is, however, noted that the center region 10E is not an essential element for the polarization converting element 10.

In the present embodiment, circumferential polarization annular illumination (modified illumination in which beams passing through the annular secondary light source are set in the circumferential polarization state) is implemented as follows: the depolarizer 4c of the polarization state switch 4 is retracted from the illumination optical path, and the angular position of the crystallographic axis of the half-wave plate 4b is so adjusted around the optical axis as to make Z-directionally polarized light incident to the diffractive optical element 5 for annular illumination, whereby linearly polarized light having the polarization direction along the Z-direction is made incident to the polarization converting element 10. As a result, as shown in Fig. 4, the annular secondary light source (annular illumination pupil distribution) 31 is formed on or near the rear focal plane of the micro fly's eye lens 11, and beams passing through this annular secondary light source 31 are set in the circumferential polarization state. In the circumferential polarization state, beams passing through the respective arcuate regions 31A-31D constituting the annular secondary light source 31 are in a linear polarization state with the polarization direction approximately coincident with a direction of a tangent to a circle centered around the optical axis AX, at the center position along the circumferential direction of each arcuate region 31 A-31 D.

In this manner, the present embodiment is able to form the annular secondary light source 31 in the circumferential polarization state, without substantive occurrence of loss in quantity of light, through the optically rotating operation of the polarization converting element 10 for converting linearly polarized light having the polarization direction substantially along a single direction, into light in the circumferential polarization state having the polarization direction substantially along the circumferential direction or into light in a radial polarization state having the polarization direction substantially along the radial direction. In other words, the illumination optical apparatus of the present embodiment is able to form the annular illumination pupil distribution in the circumferential polarization state, while well suppressing loss in quantity of light. In the circumferential polarization annular illumination based on the annular illumination pupil distribution in the circumferential polarization state, light projected onto the wafer W as a final surface to be illuminated is in a polarization state in which the principal component is s-polarized light.

The s-polarized light is defined as linearly polarized light having the polarization direction along a direction normal to the plane of incidence (i.e., polarized light whose electric vector vibrates in the direction normal to the plane of incidence). The plane of incidence is a plane defined as follows: when a ray reaches a boundary to a medium (surface to be illuminated: surface of wafer W), the plane of incidence is a plane including a normal to the boundary at the reaching point and a direction of incidence of the ray. As a result, the circumferential polarization(azimuthal polarization) annular illumination improves the optical performance (depth of focus or the like) of the projection optical system and provides a high-contrast image of the mask pattern on the wafer (photosensitive substrate).

In general, without being limited to the annular illumination, it is also possible to realize a situation wherein the light incident to the wafer W is in the polarization state in which the principal component is s-polarized light, and wherein a high-contrast image of the mask pattern is obtained on the wafer W, for example, by illumination based on a multi-pole illumination pupil distribution in the circumferential polarization state. In this case, a diffractive optical element for multi-pole illumination (dipole illumination, quadrupole illumination, octupole illumination, etc.) is set in the illumination optical path, instead of the diffractive optical element 5 for annular illumination, the depolarizer 4c is retracted from the illumination optical path, and the angular position of the crystallographic axis of the half-wave plate 4b is so adjusted around the optical axis as to make Z-directionally polarized light incident to the diffractive optical element for multi-pole illumination, whereby linearly polarized light having the polarization direction along the Z-direction is made incident to the polarization converting element 10. Furthermore, when the mask M is illuminated with linearly polarized light having the polarization direction perpendicular to the pitch direction of line patterns on the mask M, as described previously, the light incident to the wafer W is also in the polarization state in which the principal component is s-polarized light, and a high-contrast image of the mask pattern can be obtained on the wafer W.

The polarization state switch (4: 4a, 4b, 4c) and polarization converting element 10 as described above can be those proposed in International Application PCT/JP/2005/000407. It is also possible to adopt the light beam converting element and polarization converting element disclosed in International Publication WO2005/050718, instead of the diffractive optical element as a light beam shape converting element for forming a predetermined light intensity distribution of an annular, circular, multi-pole, or other shape at the position on or near the pupil plane of the illumination optical apparatus. In this case, the existing polarization converting element 10 is preferably set off the optical path, but they can also be applied in combination with this polarization converting element 10.

As described above, the illumination optical apparatus (1-15) of the present embodiment for illuminating the mask M as a surface to be illuminated, based on the light with the polarization degree of not less than 0.9 supplied from the light source 1, is provided with the polarization state switch (4: 4a, 4b, 4c) and polarization converting element 10, as a polarization setter disposed in the optical path between the light source 1 and the mask M and adapted for setting the polarization state of the light reaching the mask M, to the predetermined polarization state (including the unpolarized state).

However, for example, even in the configuration where the apparatus is arranged to illuminate the mask M (eventually, the wafer W) with light in the desired polarization state or in the unpolarized state through the operation of the polarization state switch 4 and the polarization converting element 10, if an optical element that can change the polarization state of the light is interposed in the illumination optical path, the light will fail to be focused in the desired polarization state or in the unpolarized state and this could degrade the imaging performance. Particularly, if the optical element is an optically transparent member (a lens, a plane-parallel plate, or the like) disposed in the illumination optical path, birefringence will arise with external force acting on the optically transparent member and this birefringence will cause a change in the polarization state of passing light.

Specifically, it is common practice in the conventional technology to hold an optically transparent member disposed in the illumination optical path, in a form in which it is sandwiched between spacing rings of a cylindrical shape on both sides in the lens barrel. In this case, the optically transparent member is continuously supported along a region of a circular ring centered around the optical axis, in principle. In practice, however, the optically transparent member is not continuously supported along the circular ring region but is supported in a plurality of point regions (regions not intended in particular) along the circular ring region because of influence of manufacturing error of end faces of the spacing rings (surfaces in contact with the optically transparent member) and the like.

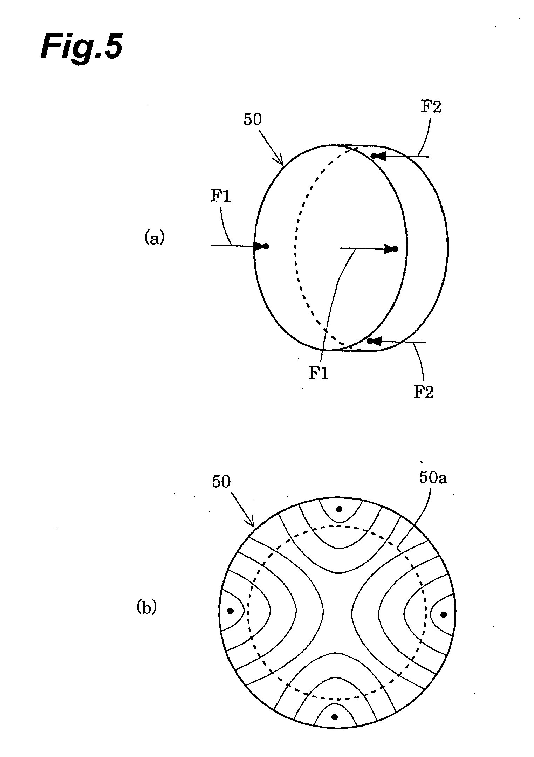

Namely, in the conventional technology, as shown in Fig. 5 (a), positions of principal forces F 1 acting from the outside on one optical surface of an optically transparent member 50 and positions of principal forces F2 acting from the outside on the other optical surface of the optically transparent member 50 do not oppose each other. As a result, as indicated by contour lines in Fig. 5 (b), a relatively large stress distribution appears over almost the entire effective region 50a of the optically transparent member 50 in response to the external forces F1 and F2, and the polarization state of the light passing through the optically transparent member 50 varies because of the birefringence occurring according to this stress distribution.

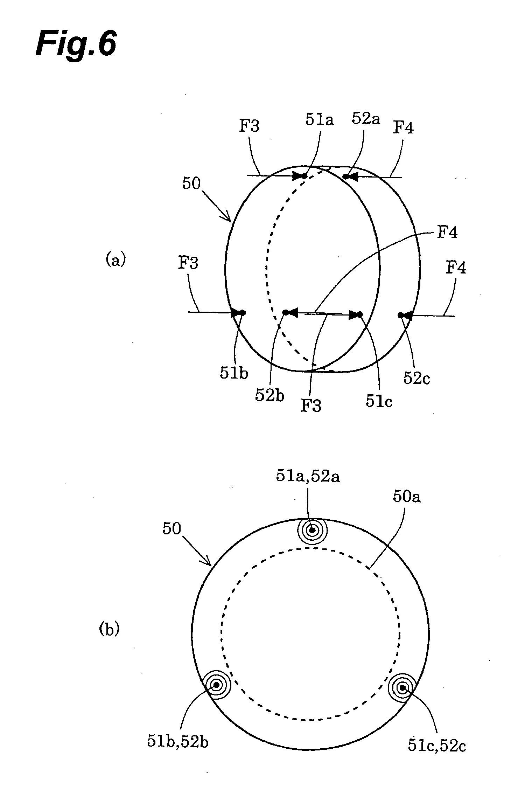

In contrast to it, in the present embodiment, as shown in Fig. 6 (a), one optical surface of the optically transparent member 50 is supported at three points located in three regions 51a-51c respectively, while the other optical surface of the optically transparent member 50 is also supported at three points located in three regions 52a-52c respectively which are approximately opposed to the three regions 51a-51c. In this case, positions of three forces F3 acting from the outside on the one optical surface of the optically transparent member 50 are approximately coincident with positions of three forces F4 acting from the outside on the other optical surface of the optically transparent member 50.

Therefore, as indicated by contour lines in Fig. 6 (b), there appear stress distributions concentrated on the supported regions 51a-51c (52a-52c) of the optically transparent member 50 in response to the external forces F3 and F4, while no substantial stress distribution appears in the effective region 50a. As a result, there occurs little birefringence due to the stress distributions in the optically transparent member supported at three points in the substantially opposed regions according to the present embodiment, and, therefore, there is little change in the polarization state of passing light due to birefringence.

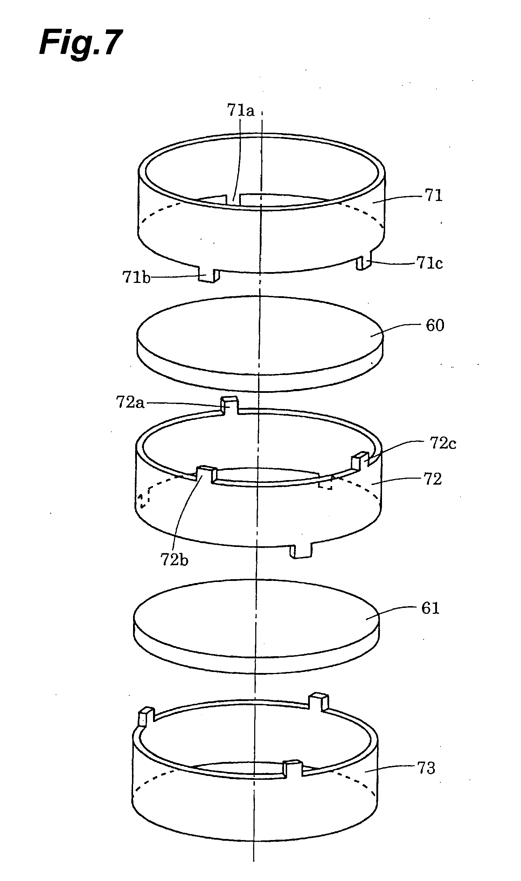

Fig. 7 is a drawing schematically showing a configuration of a holding member which supports an optically transparent member from both sides at three points in the present embodiment. The holding member of the present embodiment is provided with a first spacing ring 71 having three support portions 71a-71c for supporting one optical surface (the upper side in Fig. 7) of an optically transparent member 60 to be held, at three points located in three regions respectively (corresponding to 51a-51c in Fig. 6), and a second spacing ring. 72 having three support portions 72a-72c for supporting the other optical surface (the lower side in Fig. 7) of the optically transparent member 60, at three points located in three regions (corresponding to 52a-52c in Fig. 6).

In this configuration, the three support portions 71a-71c of the first spacing ring 71 are disposed at nearly equiangular intervals, and the three support portions 72a-72c of the second spacing ring 72 are also disposed at nearly equiangular intervals. Furthermore, the first spacing ring 71 and the second spacing ring 72 are so positioned that the support portion 71a is approximately opposed to the support portion 72a and, eventually, that the support portions 71b and 71c are approximately opposed to the support portions 72b and 72c, respectively. In this manner, the holding member (71, 72) supports the optically transparent member 60 from both sides at three points located in the three approximately opposed regions respectively.

In the illumination optical apparatus (1-15) of the present embodiment, as described above, the required optically transparent member (generally, at least one optically transparent member) among those disposed in the optical path is supported from both sides at three points in the three approximately opposed regions respectively. In this case, there appear the stress distributions concentrated on the supported regions of the optically transparent member, while no substantial stress distribution appears in the effective region of the optically transparent member. As a result, there occurs little birefringence due to the stress distributions and, therefore, there is little change in the polarization state of passing light due to birefringence.

In this manner, the illumination optical apparatus (1-15) of the present embodiment is able to well suppress the change in the polarization state of light in the optical path and to illuminate the mask M (and the wafer W eventually) as a surface to be illuminated, with light in the desired polarization state or in the unpolarized state. Therefore, the exposure apparatus of the present embodiment is able to faithfully transfer a microscopic pattern onto the wafer (photosensitive substrate) W on the basis of the desired illumination condition according to the mask pattern, using the illumination optical apparatus (1-15) for illuminating the mask M as a surface to be illuminated, with the light in the desired polarization state or in the unpolarized state.

Incidentally, the foregoing embodiment tends to cause an increase in the radial size of the optically transparent member disposed in the optical path between the micro fly's eye lens 11 as an optical integrator and the mask M as a surface to be illuminated, and to cause a change in the polarization state of passing light due to birefringence with application of external force. Therefore, in order to well suppress the change in the polarization state of light in the optical path, it is preferable to support an optically transparent member relatively large in the radial direction, out of those disposed in the optical path between the micro fly's eye lens 11 as an optical integrator and the mask M as a surface to be illuminated, at three points by the holding member.

In the foregoing embodiment, in order to well suppress the change in the polarization state of light in the optical path, it is preferable to keep an average birefringence amount not more than 2 nm/cm in the effective region of the optically transparent member in the supported state at three points by the holding member. In order to better suppress the change in the polarization state of light in the optical path, the average birefringence amount is preferably not more than 1 nm/cm.

In the foregoing embodiment, in order to restrain occurrence of stress in the radial direction of the optically transparent member in the supported state at three points by the holding member (71, 72), it is preferable to arrange a support end (an end in contact with the optically transparent member) of each support portion (71a-71c, 72a-72c) movable or flexible in a radial direction of a circle centered around the optical axis. An example of mechanically arranging the support end of the support portion movable in the radial direction can be seen in Japanese Patent Application Laid-Open No. 2002-131605.

Similarly, in order to restrain occurrence of stress in the radial direction of the optically transparent member, it is also possible to adopt a configuration wherein each of the holding members has a frame connected to each support portion and wherein each support portion is arranged to be rotatable relative to the frame. An example of rotatably arranging the lens support portions relative to the frame (lens cell) can also be seen, for example, in Japanese Patent Application Laid-Open No. 2002-131605.

In the foregoing embodiment, where an optically transparent member 61 adjacent to the optically transparent member 60 is supported from both sides at three points in three approximately opposed regions respectively by a holding member (72, 73), as shown in Fig. 7, the supported positions of the optically transparent member 60 at three points by the holding member (71, 72) are preferably arranged to positionally deviate about the optical axis from the supported positions of the optically transparent member 61 at three points by the holding member (72, 73). This configuration enables influence of the triangular support for the plurality of optically transparent members to be dispersed in the angular directions about the optical axis and is thus able to well suppress the change in the polarization state of light in the optical path. This is not limited only to the support between adjacent optically transparent members, but is also generally applicable similarly to a plurality of optically transparent members.

In the foregoing embodiment, the holding member supports the optically transparent member from both sides at three points located in the three approximately opposed regions respectively. However, without having to be limited to this, it is also possible to adopt a modification example wherein only one optical surface of an optically transparent member is supported at three points located in three regions, for example, by applying the brazing technique disclosed in Japanese Patent Application Laid-Open No. 11-228192.

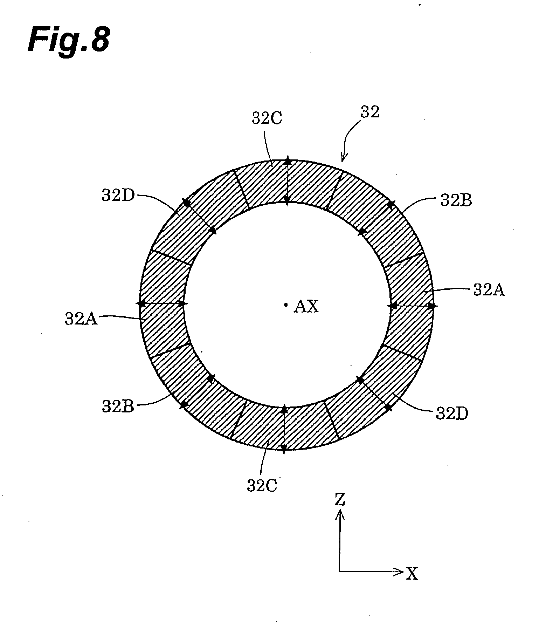

Incidentally, the foregoing embodiment can also implement radial polarization annular illumination (modified illumination in which beams passing through the annular secondary light source are set in a radial polarization state) in such a manner that linearly polarized light having the polarization direction along the X-direction is made incident to the polarization converting element 10 to set the beams passing through the annular secondary light source 32 to the radial polarization state as shown in Fig. 8. In the radial polarization state, the beams passing through respective arcuate regions 32A-32D constituting the annular secondary light source 32 are in a linear polarization state with the polarization direction approximately coincident with a radial direction of a circle centered around the optical axis AX, at the center position along the circumferential direction of each arcuate region 32A-32D.

In the radial polarization annular illumination based on the annular illumination pupil distribution in the radial polarization state, the light projected onto the wafer W as a final surface to be illuminated is in a polarization state in which the principal component is p-polarized light. The p-polarized light herein is linearly polarized light having the polarization direction along a direction parallel to the plane of incidence defined as described previously (i.e., polarized light whose electric vector vibrates in the direction parallel to the plane of incidence). As a result, the radial polarization annular illumination allows us to obtain a good mask pattern image on the wafer (photosensitive substrate) while controlling the reflectance of light to a low level on the resist applied to the wafer W.

The foregoing embodiment is arranged to switch the light beam incident to the polarization converting element 10 between the linear polarization state with the polarization direction along the Z-direction and the linear polarization state with the polarization direction along the X-direction, thereby implementing the circumferential polarization annular illumination and the radial polarization annular illumination. However, how to implement the circumferential polarization annular illumination and the radial polarization annular illumination is not limited to this method, but it is also possible to implement the circumferential polarization annular illumination and the radial polarization annular illumination, for example, by switching the polarization converting element 10 between a first state of the polarization converting element 10 shown in Fig. 2 and a second state in which the polarization converting element 10 is rotated by 90° around the optical axis AX from the first state, for the incident light beam in the linear polarization state having the polarization direction along the Z-direction or along the X-direction.

In the foregoing embodiment, the polarization converting element 10 is disposed immediately before the micro fly's eye lens 11. However, without having to be limited to this, the polarization converting element 10 can also be disposed, for example, on or near the pupil of the projection optical system PL, on or near the pupil of the imaging optical system 15, or immediately before the conical axicon system 8 (on or near the pupil of the afocal lens 6).

However, if the polarization converting element 10 is disposed in the projection optical system PL or in the imaging optical system 15, the required effective diameter of the polarization converting element 10 will tend to become large and thus this configuration is not so preferable in view of the present status in which it is difficult to obtain a large rock crystal substrate with high quality. When the polarization converting element 10 is disposed immediately before the conical axicon system 8, the required effective diameter of the polarization converting element 10 can be kept small, but the distance becomes longer to the wafer W being the final surface to be illuminated, to raise a possibility that an element to change the polarization state, such as an antireflection coat on a lens or a reflecting film of a mirror, is interposed in the optical path to the wafer, which is not so preferred. In passing, the antireflection coat on the lens and the reflecting film of the mirror are likely to produce a difference in reflectance depending upon the polarization states (p-polarization and s-polarization) and angles of incidence and are thus likely to change the polarization state of light.

In the foregoing embodiment, at least one surface of the polarization converting element 10 (e.g., the exit surface) is uneven and the polarization converting element 10 has the thickness distribution varying discretely (discontinuously) in the circumferential direction eventually. However, without having to be limited to this, at least one surface of the polarization converting element 10 (e.g., the exit surface) can be formed in such a curved shape that the polarization converting element 10 has a thickness distribution varying approximately discontinuously in the circumferential direction.

In the foregoing embodiment, the polarization converting element 10 is constructed of the eight basic elements of the sector shape corresponding to the eight segments of the annular effective region. However, without having to be limited to this, the polarization converting element 10 can also be constructed of eight basic elements of a sector shape corresponding to eight segments of a circular effective region, or of four basic elements of a sector shape corresponding to four segments of a circular or annular effective region, or of sixteen basic elements of a sector shape corresponding to sixteen segments of a circular or annular effective region. Namely, it is possible to adopt a variety of modification examples as to the shape of the effective region of the polarization converting element 10, the number of segments of the effective region (the number of basic elements), and so on.

In the foregoing embodiment, each of the basic elements 10A-10D (consequently, the polarization converting element 10) is made of rock crystal. However, without having to be limited to this, each basic element can also be made of another appropriate optical material with optical rotation. In this case, it is preferable to use an optical material with the optical rotation of not less than 100°/mm for the light of wavelength used. Namely, it is not preferable to use an optical material with a small value of optical rotation because the thickness enough to obtain the required rotation angle of the polarization direction becomes so large as to cause loss in quantity of light.

In the foregoing embodiment, the polarization converting element 10 is fixed relative to the illumination optical path, but this polarization converting element 10 may be so arranged that it can be inserted into and retracted from the illumination optical path. The foregoing embodiment showed the example of the combination of the annular illumination with s-polarized light for the wafer W, but it is also possible to adopt one of combinations of multi-pole illuminations, such as dipole illumination and quadrupole illumination, and circular illumination with s-polarized light for the wafer W. In the foregoing embodiment, the illumination conditions for the mask M and the imaging conditions (numerical aperture, aberration, etc.) for the wafer W can be automatically set, for example, according to the type of the pattern of the mask M or the like.

In the foregoing embodiment, where the optical system (the illumination optical system or the projection optical system) on the wafer W side with respect to the polarization converting element 10 has polarization aberration (retardation), this polarization aberration can cause change in the polarization direction. In this case, the direction of the polarization plane rotated by the polarization converting element 10 may be set in view of the influence of polarization aberration of these optical systems. When a reflecting member is disposed in the optical path on the wafer W side with respect to the polarization converting element 10, a phase difference can arise for every polarization direction of reflection by this reflecting member. In this case, the direction of the polarization plane rotated by the polarization converting element 10 may be set in view of the phase difference of the light beam caused by the polarization characteristic of the reflecting surface. The adjustment may be performed by means of the wave plates 4a, 4b so that the desired polarization state is achieved on the entrance plane of the polarization converting element 10.

Although the micro fly's eye lens 11 of the wavefront dividing type is used as an optical integrator in the foregoing embodiment, instead thereof, a rod type integrator of an internal reflection type, for example, as disclosed in Japanese Patent Application Laid-Open No. 2005-116831, may also be applied. In this case, preferably, one optical surface of at least one optically transparent member (5, 6, 11, 13R, 16, or 18) among those in the optical path between the polarization controlling member 4 as a polarization setter and the surface to be illuminated is supported at three points located in three regions.

In application of the rod type integrator, there is a case where a polarization selecting member is disposed near the pupil position of the illumination imaging optical system for guiding an almost uniform illumination region formed on the exit surface of the rod type integrator, to the surface to be illuminated, for example, as disclosed in International Publication WO2005/024516. In this case, preferably, an optical surface of at least one optically transparent member among the optical members in the optical path between the polarization selecting member 10 as a polarization setter and the surface to be illuminated is supported at three points located in three regions.

In a case where a polarization converting member for converting unpolarized light into linearly polarized light is disposed near the pupil position of the illumination imaging optical system for guiding an almost uniform illumination region formed on the exit surface of the rod type integrator, to the surface to be illuminated, for example, as disclosed in International Publication WO2005/050325, preferably, one optical surface of at least one optically transparent member among the optical members in the optical path between the polarization converting member 22 as a polarization setter and the surface to be illuminated is supported at three points located in three regions.

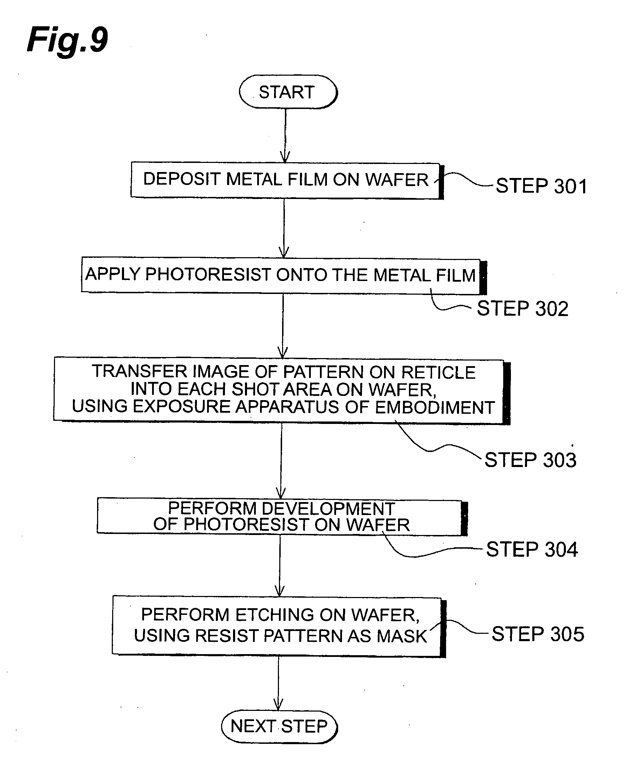

The exposure apparatus of the foregoing embodiment can be used to manufacture microdevices (semiconductor devices, image pickup devices, liquid-crystal display devices, thin-film magnetic heads, etc.) by illuminating a mask (reticle) by the illumination optical apparatus (illumination step) and projecting a pattern to be transferred, formed in the mask, onto a photosensitive substrate with the projection optical system (exposure step). An example of a technique of forming a predetermined circuit pattern on a wafer or the like as a photosensitive substrate with the exposure apparatus of the foregoing embodiment to obtain semiconductor devices as microdevices will be described below with reference to the flowchart of Fig. 9.

The first step 301 in Fig. 9 is to deposit a metal film on each wafer in one lot. The next step 302 is to apply a photoresist onto the metal film on each wafer in the one lot. The subsequent step 303 is to sequentially transfer an image of a pattern on the mask into each shot area on each wafer in the one lot through the projection optical system, using the exposure apparatus of the foregoing embodiment. The subsequent step 304 is to perform development of the photoresist on each wafer in the one lot and the subsequent step 305 is to perform etching on each wafer in the one lot, using the resist pattern as a mask, and thereby to form a circuit pattern corresponding to the pattern on the mask, in each shot area on each wafer. Subsequent steps include formation of circuit patterns in upper layers, and others, thereby manufacturing devices such as semiconductor devices. The above-described semiconductor device manufacturing method permits us to obtain semiconductor devices with extremely fine circuit patterns at high throughput.

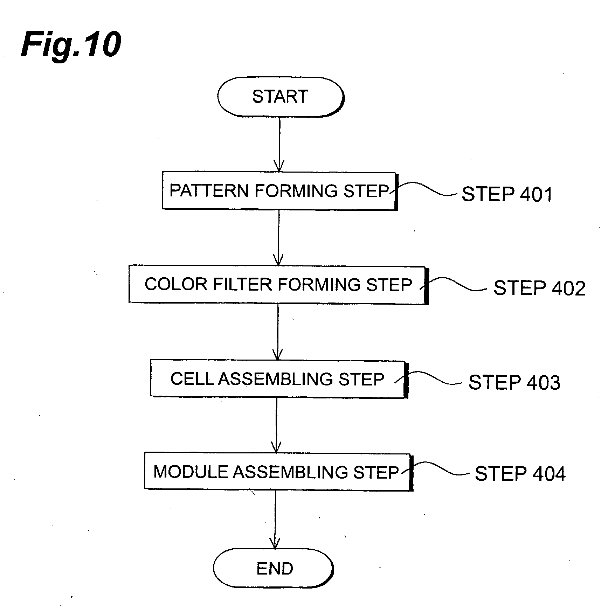

The exposure apparatus of the foregoing embodiment can also be used to manufacture a liquid-crystal display device as a microdevice by forming predetermined patterns (circuit pattern, electrode pattern, etc.) on plates (glass substrates). An example of a technique in this case will be described with reference to the flowchart of Fig. 10. In Fig. 10, a pattern forming step 401 is to execute a so-called photolithography step to transfer a pattern of a mask onto a photosensitive substrate (glass substrate coated with a resist, or the like) with the exposure apparatus of the foregoing embodiment. This photolithography step results in forming the predetermined pattern including a number of electrodes and others on the photosensitive substrate. Thereafter, the exposed substrate is subjected to each of steps such as development, etching, and resist removal, whereby a predetermined pattern is formed on the substrate. Thereafter, the process shifts to the next color filter forming step 402.

The next color filter forming step 402 is to form a color filter in which a number of sets of three dots corresponding to R (Red), G (Green), and B (Blue) are arrayed in a matrix pattern, or in which sets of three stripe filters of R, G, and B are arrayed as a plurality of lines along the horizontal scan line direction. After completion of the color filter forming step 402, a cell assembling step 403 is carried out. The cell assembling step 403 is to assemble a liquid crystal panel (liquid crystal cell), using the substrate with the predetermined pattern obtained in the pattern forming step 401, the color filter obtained in the color filter forming step 402, and so on.

In the cell assembling step 403, for example, a liquid crystal is poured into between the substrate with the predetermined pattern obtained in the pattern forming step 401 and the color filter obtained in the color filter forming step 402, to manufacture a liquid crystal panel (liquid crystal cell). The subsequent module assembling step 404 is to install each of components such as an electric circuit, a backlight, etc. for display operation of the assembled liquid crystal panel (liquid crystal cell) to complete the liquid-crystal display device. The above-described method of manufacturing the liquid-crystal display device permits us to obtain the liquid-crystal display device with an extremely fine circuit pattern at high throughput.

In the foregoing embodiment, the KrF excimer laser light (wavelength: 248 nm) or the ArF excimer laser light (wavelength: 193 nm) is used as the exposure light, but, without having to be limited to these, the present invention is also applicable to other appropriate laser light sources, e.g., an $F_2$ laser light source for supplying a laser beam of wavelength of 157 nm. Furthermore, the present invention is described using the example of the exposure apparatus with the illumination optical apparatus in the foregoing embodiment, but it is apparent that the present invention is applicable to ordinary illumination optical apparatus for illuminating other surfaces to be illuminated.

In the foregoing embodiment, it is also possible to adopt a technique of filling the optical path between the projection optical system and the photosensitive substrate with a medium having the refractive index of more than 1.1 (typically, a liquid), i.e., the so-called liquid immersion method. In this case, the technique of filling the liquid in the optical path between the projection optical system and the photosensitive substrate can be one selected from the method of locally filling the space with the liquid as disclosed in International Publication WO99/49504, the method of moving a stage holding a substrate as an exposed object, in a liquid bath as disclosed in Japanese Patent Application Laid-Open No. 6-124873, the method of forming a liquid bath of a predetermined depth on a stage and holding a substrate in the liquid bath as disclosed in Japanese Patent Application Laid-Open No. 10-303114, and so on.

The liquid is preferably one that is transparent to exposure light, that has the refractive index as high as possible, and that is stable against the projection optical system and the photoresist applied on the surface of the substrate; for example, and if the KrF excimer laser light or the ArF excimer laser light is used as exposure light, the liquid can be pure water or deionized water. In case where the exposure light is the $F_2$ laser light, the liquid can be a fluorine-based liquid, for example, such as fluorine oil or perfluoro polyether (PFPE) capable of transmitting the $F_2$ laser light.

Description of Reference Symbols

| | |
|---|---|
| 1 | light source |
| 4 | polarization state switch |
| 4a | quarter-wave plate |
| 4b | half-wave plate |
| 4c | depolarizer |
| 5 | diffractive optical element (light beam converting element) |

| | |
|---|---|
| 6 | afocal lens |
| 8 | conical axicon system |
| 9 | zoom lens |
| 10 | polarization converting element |
| 10A-10D | basic elements |
| 11 | micro fly's eye lens |
| 12 | polarization monitor |
| 12a | beam splitter |
| 13 | condenser optical system |
| 14 | mask blind |
| 15 | imaging optical system |
| 60, 61 | optically transparent members |
| 71, 72, 73 | spacing rings (holding member) |
| 71a-71c, 72a-72c | support portions |
| M | mask |
| PL | projection optical system |
| W | wafer |

**Claims**

1. An illumination optical apparatus for illuminating a surface to be illuminated, the illumination optical apparatus comprising:

   a polarization setter disposed in an optical path between a light source for supplying light having a polarization degree of not less than 0.9, and the surface to be illuminated, and adapted for setting a polarization state of light reaching the surface to be illuminated, to a predetermined polarization state; and
   a holding member for supporting one optical surface of at least one optically transparent member incorporated in an optical system in the optical path between the light source and the surface to be illuminated, at three points located in three regions respectively.

2. An illumination optical apparatus according to claim 1, wherein the holding member supports an other optical surface of the optically transparent member, at three points located in three regions respectively which are substantially opposed to said three regions of said one optical surface of the optically transparent member.

3. An illumination optical apparatus according to claim 1 or 2, wherein the holding member supports one optical surface of at least one optically transparent member incorporated in an optical system in an optical path between the polarization setter and the surface to be illuminated, at three points located in three regions respectively.

4. An illumination optical apparatus according to any one of claims 1 to 3, further comprising a polarization converting element for converting a polarization state of incident light into a predetermined polarization state,
   wherein the holding member supports one optical surface of at least one optically transparent member incorporated in an optical system in an optical path between the polarization converting element and the surface to be illuminated, at three points located in three regions respectively.

5. An illumination optical apparatus according to claim 4, wherein the polarization converting element is disposed between the polarization setter and the surface to be illuminated.

6. An illumination optical apparatus according to claim 4 or 5, wherein the polarization converting element converts linearly polarized light having a polarization direction substantially along a single direction, into light in a circumferential polarization state having a polarization direction substantially along a circumferential direction or into light in a radial polarization state having a polarization direction substantially along a radial direction.

7. An illumination optical apparatus according to any one of claims 4 to 6, wherein the polarization converting element is disposed on or near a pupil of the illumination optical apparatus.

8. An illumination optical apparatus according to any one of claims 1 to 7, further comprising an optical integrator for forming a substantive surface light source on an illumination pupil plane on the basis of the light beam from the light source,
   wherein said at least one optically transparent member is disposed in an optical path between the optical integrator and the surface to be illuminated.

9. An illumination optical apparatus according to claim 8, further comprising:

   a condenser optical system disposed in an optical path between the optical integrator and a surface optically conjugate with the surface to be illuminated, and arranged to converge a light beam from the optical integrator and guide the converged light beam to the surface optically conjugate with the surface to be illuminated; and
   an illumination imaging optical system disposed in an optical path between the condenser optical system and the surface to be illuminated and arranged to guide light from the surface optically conjugate with the surface to be illuminated, to the surface to be illuminated,

   wherein said at least one optically transparent member is disposed in the illumination imaging optical system.

**10.** An illumination optical apparatus according to any one of claims 1 to 7, further comprising:

an optical integrator for forming a substantially uniform illumination region on a surface substantially optically conjugate with the surface to be illuminated, based on the light beam from the light source; and

an illumination imaging optical system disposed in an optical path between the optical integrator and the surface to be illuminated, and arranged to guide light from the surface substantially optically conjugate with the surface to be illuminated, to the surface to be illuminated,

wherein said at least one optically transparent member is disposed in the illumination imaging optical system.

**11.** An illumination optical apparatus according to claim 10, wherein the polarization setter is disposed in the illumination imaging optical system, and wherein said at least one optically transparent member is disposed in an optical path between the polarization setter and the surface to be illuminated.

**12.** An illumination optical apparatus according to any one of claims 1 to 11, wherein in a supported state at three points by the holding member, an average birefringence amount in an effective region of said at least one optically transparent member is not more than 2 nm/cm.

**13.** An illumination optical apparatus according to any one of claims 1 to 12, wherein the holding member has three support portions for supporting said at least one optically transparent member in the respective regions, and wherein a support end of each support portion is movable or flexible in a radial direction of a circle centered around the optical axis.

**14.** An illumination optical apparatus according to any one of claims 1 to 12, wherein the holding member supports an other optical surface of the optically transparent member, at three points located in three regions respectively which are substantially opposed to said three regions of the one optical surface of the optically transparent member, and has six support portions for supporting said at least one optically transparent member in respective regions, and wherein a support end of each support portion is movable or flexible in a radial direction of a circle centered around the optical axis.

**15.** An illumination optical apparatus according to any one of claims 1 to 12, wherein the holding member comprises three support portions for supporting said at least one optically transparent member in the respective regions, and a frame connected to said three support portions, and wherein said three support portions are rotatable relative to the frame.

**16.** An illumination optical apparatus according to any one of claims 1 to 15, wherein the holding member has a first holding member for supporting a first optically transparent member at three points, and a second holding member for supporting a second optically transparent member at three points, and wherein the three points of the first optically transparent member supported by the first holding member substantially positionally deviate around an optical axis from the three points of the second optically transparent member supported by the second holding member.

**17.** An exposure apparatus comprising the illumination optical apparatus as defined in any one of claims 1 to 16, for illuminating a mask, the exposure apparatus being adapted for exposure of a pattern of the mask on a photosensitive substrate.

**18.** An exposure method comprising an illumination step of illuminating a mask by means of the illumination optical apparatus as defined in any one of claims 1 to 16; and an exposure step of effecting exposure of a pattern of the mask on a photosensitive substrate.

Fig.1

# Fig.2

# Fig.3

## *Fig.4*

# Fig.5

(a)

(b)

# Fig.6

(a)

F3    51a  52a  F4

50

F4

F3    F4

51b    52c

52b  F3  51c

(b)

51a,52a    50a

50

51b,52b    51c,52c

# *Fig.7*

71a

71

71b

71c

60

72a

72c

72

72b

61

73

# *Fig.8*

# Fig.9

```
        ( START )
            │
            ▼
┌──────────────────────────────┐
│ DEPOSIT METAL FILM ON WAFER  │ ── STEP 301
└──────────────────────────────┘
            │
            ▼
┌──────────────────────────────┐
│ APPLY PHOTORESIST ONTO THE   │
│ METAL FILM                   │ ── STEP 302
└──────────────────────────────┘
            │
            ▼
┌──────────────────────────────────────┐
│  TRANSFER IMAGE OF PATTERN ON RETICLE │
│     INTO EACH SHOT AREA ON WAFER,     │
│ USING EXPOSURE APPARATUS OF EMBODIMENT│ ── STEP 303
└──────────────────────────────────────┘
            │
            ▼
┌──────────────────────────────┐
│    PERFORM DEVELOPMENT        │
│  OF PHOTORESIST ON WAFER      │ ── STEP 304
└──────────────────────────────┘
            │
            ▼
┌──────────────────────────────┐
│   PERFORM ETCHING ON WAFER,   │
│ USING RESIST PATTERN AS MASK │ ── STEP 305
└──────────────────────────────┘
            │
            ▼
      ( NEXT STEP )
```

# *Fig.10*

```
                    ┌─────────────┐
                    │    START    │
                    └──────┬──────┘
                           │
                           ▼
        ┌──────────────────────────────┐
        │    PATTERN FORMING STEP       │ ───── STEP 401
        └───────────────┬──────────────┘
                        │
                        ▼
      ┌────────────────────────────────┐
      │    COLOR FILTER FORMING STEP    │ ───── STEP 402
      └────────────────┬───────────────┘
                       │
                       ▼
      ┌────────────────────────────────┐
      │    CELL ASSEMBLING STEP         │ ───── STEP 403
      └────────────────┬───────────────┘
                       │
                       ▼
      ┌────────────────────────────────┐
      │    MODULE ASSEMBLING STEP       │ ───── STEP 404
      └────────────────┬───────────────┘
                       │
                       ▼
                ┌─────────────┐
                │     END     │
                └─────────────┘
```

## INTERNATIONAL SEARCH REPORT

| | International application No. |
|---|---|
| | PCT/JP2005/013410 |

A.  CLASSIFICATION OF SUBJECT MATTER
*H01L21/027* (2006.01), *G03F7/20* (2006.01), *G02B5/30* (2006.01), *G02B7/02* (2006.01), *G02B7/00* (2006.01), *G02B13/24* (2006.01)

According to International Patent Classification (IPC) or to both national classification and IPC

B.  FIELDS SEARCHED

Minimum documentation searched (classification system followed by classification symbols)
*G01L21/027* (2006.01), *G03F7/20* (2006.01), *G02B5/30* (2006.01), *G02B7/02* (2006.01), *G02B7/00* (2006.01), *G02B13/24* (2006.01)

Documentation searched other than minimum documentation to the extent that such documents are included in the fields searched
Jitsuyo Shinan Koho          1922-1996     Jitsuyo Shinan Toroku Koho     1996-2005
Kokai Jitsuyo Shinan Koho    1971-2005     Toroku Jitsuyo Shinan Koho     1994-2005

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 2002-141270 A  (Nikon Corp.),<br>17 May, 2002 (17.05.02),<br>Page 1; Claims; Par. Nos. [0007] to [0009],<br>[0042]<br>(Family: none) | 1-18 |
| Y | WO 2004/051717 A1  (Nikon Corp.),<br>17 June, 2004 (17.06.04),<br>Abstract; Claims; Fig. 1<br>& AU 2003289126 A1 | 1-18 |
| Y | JP 2004-111678 A  (Canon Inc.),<br>08 April, 2004 (08.04.04),<br>Claims; Par. No. [0027]; Fig. 16<br>& US 2004/0057036 A1 | 1-18 |

☒  Further documents are listed in the continuation of Box C.      ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 October, 2005 (13.10.05) | 25 October, 2005 (25.10.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
| --- |
| PCT/JP2005/013410 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2001-274083 A  (CARL ZEISS),<br>05 October, 2001 (05.10.01),<br>Page 1; Claims<br>& DE 10010131 A1          & EP 1130470 A2<br>& US 2001/0019404 A1 | 1-18 |
| A | JP 2002-156571 A  (Nikon Corp.),<br>31 May, 2002 (31.05.02),<br>Page 1; Par. No. [0035]<br>(Family: none) | 1-18 |
| A | JP 2001-343576 A  (Canon Inc.),<br>14 December, 2001 (14.12.01),<br>Claims<br>& US 2001/0039126 A1 | 1-18 |
| A | JP 2003-172857 A  (Canon Inc.),<br>20 June, 2003 (20.06.03),<br>Claims<br>(Family: none) | 1-18 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3246615 B
- JP 2005000407 W
- WO 2005050718 A
- JP 2002131605 A
- JP 11228192 A
- JP 2005116831 A

- WO 2005024516 A
- WO 2005050325 A
- WO 9949504 A
- JP 6124873 A
- JP 10303114 A